# EUROPEAN PATENT APPLICATION

(11) **EP 0 800 890 A1**
(43) Date of publication of application: **15.10.1997**
(21) Application number: 97302322.9
(22) Date of filing: 04.04.1997
(51) Int. Cl.: B23P 11/00, B21K 25/00, H01L 23/367

(54) **Heat sink**

(30) Priority: 08.04.1996 JP 120759/96; 24.06.1996 JP 198241/96; 05.08.1996 JP 237120/96
(71) Applicant: Tousui Ltd, Toride-shi, Ibaragi-ken (JP)
(72) Inventor: Terada, Atsushi, Toride-shi, Ibaragi-ken (JP)
(74) Representative: Parry, Christopher Stephen

(57) **Abstract**

In order to produce, e.g., an improved heat sink, there is disclosed, in the most comprehensive aspect of the invention, a method of joining together a pair of members each having a high thermal conductivity, which method comprises the steps of: forming a first of the two thermally high conductivity members (1,2), at a joining surface thereof, with either of a plurality of projecting portions and a plurality of projecting and recessed portions; forming a second of the said two members, at a joining surface thereof, with either of a plurality of recessed portions each of which corresponds to a selected one of the said projecting portions and a plurality of projecting portions each of which corresponds to a selected one of the recessed portions of the said projecting and recessed portions of the said first member; and inserting under pressure each of the said projecting portions of one of the said two members (1,2) into each of the said recessed portions that corresponds thereto, of another of the said two thermally high conductivity members, with a tolerance that is sufficient to induce a plastic deformation in each of the said members. A variety of improved heat sinks prepared using the method described are also disclosed.

## Description

The present invention relates to a heat sink and a method of assembling a heat sink and, more generally, a method of joining together a pair of extruded materials each having a high thermal conductivity and a product made by the method.

In our earlier filed pending European patent application No. 96301406.3 filed 1 March 1996 (EP 0744 241 published 27 November 1996), it has been pointed out that where a pair of members each having a high thermal conductivity, for example, a pair of aluminum members, are to be joined together with their thermal conductivity and electrical conductivity taken into consideration, difficulties have hitherto be encountered because they have a high capacity of heat radiation and would have been formed with an oxide film on the surface of each of these members. Thus, even by means of resistance welding or brazing, it has been found to be more difficult to join these members together than to join a pair of other metallic materials together which have rather ordinarily been used, these other materials having a limited thermal conductivity and a reasonable degree of electric resistivity.

In addition, where a pair of extruded members are to be joined together, the size of a product that is yieldable has been limited by the size of an extrusion die that can be employed. The extrusion technique is typically unable to give rise to a product that is not less than 500 mm in its width. If a product with its width more than 500 mm and having a high thermal conductivity is then to be manufactured, any attempt has been believed to be useless, say, unless a plurality of smaller products are to be welded together.

For these reasons, if a product such as a heat sink, for example, has a specification that requires a surface (hereinafter referred to a "base") to which a heat generating element is attached and which exceeds 500 mm in its width, there has hitherto been no choice but to give up a production with extruded materials or, alternatively, to join a plurality of bases together by way of welding. Although there has also been a way of fitting a pair of corrugated plates together, such a fitting alone has been found to be insufficient to fully meet the need of a thermal conductivity and an electrical conductivity which are customarily required for a heat sink.

Also, in preparing a heat sink that utilizes a liquid coolant, it has been found to be too costly if a brazing process is employed to affix a pair of plates together. Further, for example, if a die is made up from a lost wax, the die will have been reformed because of the two sizes required.

Accordingly, it is an object of the present invention to resolve the above mentioned deficiencies in the prior art and to provide an improved heat sink and an improved method of assembling such a heat sink as well as a method of joining a pair of extruded members each having a high thermal (as well as a high electrical) conductivity in order to yield a product that has an joined interface that is high in both the thermal conductivity and the electrical conductivity as well as to provide an improved product made by a method as described.

In order to achieve the object mentioned above, there is provided in accordance with the present invention, in a first general aspect thereof, a method of joining together a pair of extruded members each having a high thermal conductivity, which method comprises the steps of: forming a first of the two thermally high conductivity members, at a joining surface thereof, with either of a plurality of projecting portions and a plurality of projecting and recessed portions; forming a second of the said two members, at a joining surface thereof, with either of a plurality of recessed portions each of which corresponds to a selected one of the said projecting portions and a plurality of projecting portions each of which corresponds to a selected one of the recessed portions of the said projecting and recessed portions of the said first member; sizing a width of a said projecting portion so as to be substantially identical to, or, preferably, slightly greater than, a width of a said recessed portions and forcibly inserting under pressure each of the said projecting portions of one of the said two members into each of the said recessed portions that corresponds thereto, of another of the said two thermally high conductivity members, with a tolerance that is sufficient to induce a plastic deformation in each of the said members.

The present invention also provides, in a second aspect thereof, a method of joining together a pair of extruded members each having a high thermal conductivity, which method comprises the steps of: forming a first of the two thermally high conductivity members, at a joining surface thereof, with either of a plurality of projecting portions and a plurality of projecting and recessed portions; forming a second of the said two members, at a joining surface thereof, with either of a plurality of recessed portions each of which corresponds to a selected one of the said projecting portions and a plurality of projecting portions each of which corresponds to a selected one of the recessed portions of the said projecting and recessed portions of the said first member; providing each of at least some of the said projecting portions and the said recessed portions with a portion which is inclined with a given angle; sizing a width of a said projecting portion so as to be substantially identical to, or, preferably, slightly greater than, a width of a said recessed portion; forcibly inserting under pressure each of the said projecting portions of one of the said two members into each of the said recessed portions that corresponds thereto, of another of the said two members; in a stage in which the said projecting portions are inserted under pressure into the said corresponding recessed portions, dynamically affecting areas of the said at least some of the said projecting portions and the said recessed portions with such portions each as inclined with the said given angle, thereby plastically the said areas; and, as a result of the plastic deformation of the said areas, effecting a work hardening thereof so as to enhance a tightness of fastening between the said two thermally high conductivity members.

The present invention further provides, in a third aspect thereof, a method of joining together a pair of extruded members each having a high thermal conductivity, which method comprises the steps of: forming a first of the two thermally high conductivity members, at a joining surface thereof, with either of a plurality of projecting portions and a plurality of projecting and recessed portions; forming a second of the said two members, at a joining surface thereof, with either of a plurality of recessed portions each of which corresponds to a selected one of the said projecting portions and a plurality of projecting portions each of which corresponds to a selected one of the recessed portions of the said projecting and recessed portions of the said first member; providing each of at least some of the said projecting portions and said recessed portions with a portion that is inclined with a given angle; sizing a width of a said projecting portion so as to be substantially identical to, or, preferably, slightly slightly greater than, a width of a said recessed portion; forcibly inserting under pressure each of the said projecting portions of one of the said two members into each of the said recessed portions that corresponds thereto, of another of the said two members, with a tolerance that is sufficient to induce a plastic deformation in each of the said members; in a stage in which the said projecting portions are inserted under pressure into the said corresponding recessed portions, dynamically affecting areas of the said at least some of the said projecting portions and the said recessed portions with such portions each as inclined with the said given angle, thereby plastically deforming the said areas; and, as a result of the plastic deformation of the said areas, effecting a work hardening thereof so as to enhance a tightness of fastening between the said two thermally high conductivity members.

According to a concomitant feature of the present invention, the said members are each made up from a metallic material; and the method further comprising the steps of: providing each of at least some of the said projecting portions and the said recessed portions, which correspond to the said recessed portions and the said projecting portions in joining, with a portion that is inclined with a given angle; and, in a stage in which the said projecting portions are inserted under pressure into the said corresponding recessed portions, developing a frictional action and a caulking action between each pair of at least some of the said enterring metallic projecting portions and at least some of the said receiving metallic recessed portions which correspond thereto, developing an internal stress from a contraction and an expansion of each of said entering metallic projecting portions and each of said receiving metallic recessed portions, respectively, under said pressure, and joining the said enterring projecting portions and said receiving recessed portions together under a combined effect of the said frictional and caulking actions and the said internal stress under the said pressure.

According to another concomitant feature of the present invention, the said pair of thermally high conductivity members are each constituted by a base plate for a heat sink assembly.

According to a further concomitant feature of the present invention, the method of joining is characterized in that the said two thermally conductivity members are constituted by a base plate and fin means, respectively, for a heat sink assembly.

The present invention still further covers a product that is made according to a method of joining a pair of members each having a high thermal conductivity.

Thus, in joining together a pair of extruded members each having a high thermal conductivity (as well as a high electrical conductivity), by virtue of the fact that a first of the two thermally high conductivity members to be joined together is formed on a joining surface thereof with either of a plurality of projecting portions and a plurality of projecting and recessed portions; a second of the said extruded members is formed on a joining surface thereof with either of a recessed portion that corresponds to a selected one of the said projecting portions and a projecting portion that corresponds to a selected one of the recessed portions of the said projecting and recessed portions of the said first member; the width of a said projecting portion is substantially identical to, or, preferably, slightly greater than the width of a said recessed portion, and each of the said projecting portions of one of the said two members is forcibly inserted under pressure into each of said recessed portions that corresponds thereto, of another of the said two extruded members, with a tolerance that is sufficient to induce a plastic deformation in each of the said member, an enhanced tightness of fastening between the two thermally high conductivity members together is attained.

Also, in joining a pair of such extruded members together, by virtue of the fact that each of at least some of the said projecting portions and the said recessed portions is provided with a portion that is inclined with a given angle; in a stage in which the said projecting portions are inserted under pressure into the said corresponding recessed portions, areas of the said at least some of the said projecting portions and the said recessed portions are dynamically affected by the provision of such portions each as inclined with the said given angle and are thereby plastically deformed; and as a result of the plastic deforming of the said areas, a work hardening thereof is effected, a further enhanced tightness of fastening between the said two thermally high conductivity members is achieved.

Also, in joining a pair of such extruded members together, by virtue of the fact that each of at least some of the said projecting portions and the said recessed portions, which correspond to the said recessed portions and the said projecting portions in joining, is provided with a portion that is inclined with a given angle; and in a stage in which the said projecting portions are inserted under pressure into the said corresponding recessed portions, a frictional action and a caulking action are produced between each pair of at least some of the said enterring metallic projecting portions and at least some of the said receiving metallic recessed portions which correspond thereto, and an internal stress is also produced from a contraction and an expansion of each of the said enterring metallic projecting portions and each of said receiving metallic recessed portions, respectively, under the said pressure, the said enterring projecting portions and the said reception recessed portions are tightly joined together under a combined effect of the said frictional and the said caulking action and the said internal stress, thereby enhancing both the thermal conductivity and the electrical conductivity at the joining interface of the said two thermally high conductivity members.

The present invention also provides, in a further aspect thereof, a method of assembling a heat sink, where a base plate and a plurality of fin means disposed over the base plate are assembled together by inserting the fin means fittedly into the base plate, which method comprises the steps of: forming the said fin means and the said base plate with a plurality of projecting portions and a plurality of recessed portions corresponding thereto, at a plurality of locations, respectively, at which the said plurality of fin means and the said base plate are to be fastened together, with the said plurality of projecting portions, if formed over the said fin means, being adapted to be forcibly inserted fittedly under a pressure into the said plurality of recessed portions, if formed over the said base plate and the said plurality of projecting portions, if formed over the said base plate, being adapted to be forcibly inserted fittedly under the pressure into the said plurality of the corresponding recessed portions, if formed over the said fin means, each of the said plurality of projecting portions being arranged so as to be spaced apart from one another with a predetermined distance; sizing a width of a said projecting portion so as to be substantially identical to, or, preferably, slightly greater than, a width of a said recessed portion; and forcibly inserting under the pressure the said plurality of projecting portions, if formed over the said fin means, fittedly under the pressure into said plurality of recessed portions, if formed on the said base plate and the said plurality of projecting portion, if formed over the said base plate, fittedly under the pressure into the said recessed portions,, if formed on the said fin means, thereby fastening the said plurality of fin means and the said base plate together.

The present invention also provides, in a still further aspect thereof, a heat sink in which a base plate and a plurality of fin means disposed over the base plate are assembled together by inserting the fin means fittedly into the base plate, which may be characterized in that a plurality of projecting portions and a plurality of recessed portions are formed over the said fin means and the said base plate at a plurality of locations, respectively, at which the said fin means and the said base plate are to be fastened together, with each of the said plurality of projecting portions being arranged so as to be spaced apart from one another with a predetermined distance; that a said projecting portion has a width which is substantially identical to, or, preferably, slightly greater than a width of a said recessed portion; and that under pressure, the said plurality of projecting portions if formed over the said fin means are fittedly inserted forcibly into said plurality of recessed portions if formed the said base plate whereas the said plurality of projecting portions if formed over the said base plate are fittedly forcibly inserted into the said plurality of recessed portions if formed over the said fin means so that the said plurality of fin means and the said base plate may be fastened together.

Also, a heat sink according to the present invention may further be characterized in that in at least either of the said fin means and the said base plate, the said projecting portions is provided with a first positioning portion and a first caulking portion; that at least one of the said positioning portion and the said caulking portion is inclined with a given angle; and that a stress and a drag which are produced by the said angle when under pressure, the said plurality of projecting portions if formed over the said fin means are fittedly inserted forcibly into the said base plate whereas the said plurality of projecting portions if formed over the said base plate are fittedly inserted forcibly into the said fin means, are used to further enhance the tightness of fastening between the said fin means and the said base plate.

By virtue of the fact that a plurality of projecting portions are formed over at least either of the said fin means and the said base plate at a plurality of locations, respectively, at which the said plurality of fin means and the said base plate are to be fastened together, with each of the said plurality of projecting portions being arranged so as to be spaced apart from one another with a predetermined distance and that under pressure, each of the said plurality of projecting portions is formed over said fin means and the said base plate is fittedly inserted forcibly into a corresponding recessed portion formed between the adjacent two of the said projecting portions in the said base plate and in the said fin means and having a width that is slightly smaller than that of each of the said projecting portions, the said projecting portions over the said fin means and the said projecting portions over the said base plate will be allowed to be fastened together and assembled, thereby increasing the tightness between the said fin means and the said base plate while enhancing thermal conductive between them.

According to another aspect of the invention, there is provided a method of joining together of a pair of extruded members, characterized in that the said pair of extruded members have, respectively, a first and a second surface to be joined together and are a first extruded member having either of a plurality of projecting stripes (portions) and a plurality of projecting and recessed stripes (portions) formed on the said first joining surface and a second extruded member independent thereof and having either of a plurality of recessed stripes and a plurality of recessed and projecting stripes formed on the said second joining surface, that at least some of the said stripes have each a portion which is inclined with an angle with respect to a direction that is vertical to the corresponding joining surface thereof, and that at least one of the said first and second joining surfaces has a groove formed therein having a plurality of narrower projecting stripes formed thereon, which are so adapted that when the said first and second extruded members are pressed against each other under a pressure so as to be fastened and thereby joined together by each of the said projecting stripes being forced into a said recess corresponding thereto, the said narrower projecting stripes may form, through a plastic deformation thereof, corresponding projecting stripes on a surface of an object that is sandwiched between the said first and second second extruded members.

According to a concomitant aspect of the present invention, there is also provided a method of joining together of a pair of extruded members, characterized in that the said pair of extruded members have, respectively, a first and a second surface to be joined together and are a first extruded member having either of a plurality of projecting stripes (portions) and a plurality of projecting and recessed stripes (portions) formed on the said first joining surface and a second extruded member independent thereof and having either of a plurality of recessed stripes (portions) and a plurality of recessed and projecting stripes (portions) formed on the said second joining surface, that at least some of the said stripes have each a portion which is inclined with an angle with respect to a direction that is vertical to the corresponding joining surface thereof, and that at least one of the said first and second joining surfaces has a groove formed therein having a plurality of narrower projecting stripes formed thereon, which are so adapted that when the said first and second extruded members are pressed against each other under a pressure so as to be fastened and thereby joined together by each of the said projecting stripes being forced into a said recess corresponding thereto, the said narrower projecting stripes may form, through a plastic deformation thereof, corresponding projecting stripes on a surface of an object that is sandwiched between the said first and second second extruded members, in which method the said first and second independent extruded members provides at least one surface on which a heat emitting element may be attached and that the said object which is sandwiched between the said first and second members is constituted by a tube for transporting a coolant fluid therethrough.

The invention also provides, in this aspect thereof, a liquid cooled heat sink, characterized in that a coolant fluid transporting tube which is formed in a pair of independent extruded members which have been joined together under a pressure has an external surface that is formed with narrow projecting stripes which correspond to narrow stripes formed in a groove that is formed in at least one of the said first and second extruded members.

According to the construction mentioned above, by virtue of the fact that when a pair of base plates are fitted and jointed together, they and a coolant fluid transporting pipe to be sandwiched between them are firmly fitted and joined together, it can be seen that the present invention is capable of providing a less costly heat sink product with a superior cooling effect because not only can the contact surface between the base members and the coolant fluid transporting pipe be remarkably increased but also the process steps can be markedly reduced.

According to another aspect of the present invention, there is provided a method of assembling a heat sink, comprising the steps of:
providing a fin member having a joining surface to be joined with a base plate that has a heat emitting element to be attached thereto and having a heat emitting portion comprised of a plurality of straight flat plates and a plurality of flat, bent and then flat plates which are alternately arranged and are equally spaced apart axially adjacent to the said joining surface and further having on the said joining surface any of a plurality of projecting stripes, a plurality of recessed stripes and a plurality of projecting stripes and recessed stripes;
providing the said base plate on a joining surface thereof with any of a like plurality of recessed stripes portions), a like plurality of projecting stripes (portions) and a like plurality of recessed stripes (portions) and projecting stripes (portions);
providing at least some of the said projecting stripes and recessed stripes with a predetermined angle with respect to the said joining surface on which they are provided;
forcibly inserting the said projecting stripes of one of said fin member and the said base plate under a pressure into the said recessed stripes corresponding thereto and of one of the said base member and the said fin member, thereby causing a stress therein and plastically deforming the said stripes associated with said angle, by said angle, to effect a work hardening thereof; and
utilizing an effect of the said work hardening to join the said fin member and the said base member together with an enhanced fastening strength.

According to a concomitant aspect of the above, there is also provided a heat sink prepared by:
providing a fin member having a joining surface to be joined with a base plate that has a heat emitting element to be attached thereto and having a heat emitting portion comprised of a plurality of straight flat plates and a plurality of flat, bent and then flat plates which are alternately arranged and are equally spaced apart axially adjacent to the said joining surface and further having on the said joining surface any of a plurality of projecting stripes, a plurality of recessed stripes and a plurality of projecting stripes and recessed stripes;
providing the said base plate on a joining surface thereof with any of a like plurality of recessed stripes (portions), a like plurality of projecting stripes (portions) and a like plurality of recessed stripes (portions)and projecting stripes (portions);
providing at least some of the said projecting stripes and recessed stripes with a predetermined angle with respect to the said joining surface on which they are provided;
forcibly inserting the said projecting stripes of one of the said fin member and the said base plate under a pressure into the said recessed stripes corresponding thereto and of one of the said base member and the said fin member, thereby causing a stress therein and plastically deforming the said stripes associated with the said angle, by the said angle, to effect a work hardening thereof; and
utilizing an effect of the said work hardening to join the said fin member and the said base member together with an enhanced fastening strength.

Accordingly, this aspect of the present invention provides an inexpensive and yet high performance heat sink that is prepared by applying an upstanding bend machining process to a fin member to be attached to a base plate to give a desired degree of freedom in its cooling path direction and, then, when the said fin member is fittedly attached to the base plate, utilizing a stress and a work hardening effect that is developed at the interface between them.

A further aspect of the present invention resides in a heat sink comprising:
a base plate which is made up of a first extruded member for providing an attachment surface for a heat emitting element; and
a plurality of fin sections each of which is made up of a second extruded member that is independent of the said first extruded member for emitting a heat which is transferred from the said base plate,
   characterized in that:
each of the said fin sections is provided with a fluid transport portion for accepting a coolant fluid flow and a heat emitting portion that is located above the said fluid transport portion and comprised of a plurality of flat straight plates and a plurality of flat, bent and then flat plates, and
each of said fin sections is joined with said base plate, thereby increasing the heat emitting area of such heat emitting portions thereof.

Thus, according to this aspect of the present invention, an inexpensive, light weighted and yet high performance heat sink can be manufactured by adding at the top of the fin in the heat sink in the prior art a unique heat emitting portion comprised of a plurality of flat straight plates and a plurality of flat, bent and then flat plates which are arranged alternately.

The present invention will better be understood from the following detailed description and the drawings attached hereto showing certain illustrative embodiments of the present invention. In this connection, it should be noted that such embodiments as illustrated in the accompanying drawings are intended in no way to limit the present invention, but to facilitate an explanation and understanding thereof.

In the accompanying drawings:
Fig. 1 is a perspective view diagrammatically illustrating a certain embodiment of the present invention to which the present invention has been applied to form a heat sink assembly;
Fig. 2 is a partial front view of the entire heat sink assembly shown in Fig. 1, diagrammatically illustrating a state in which fin means and a base plate has been joined together according to the present invention;
Fig. 3 is an enlarged front view diagrammatically illustrating a single fin unit in a heat sink assembly as shown in Fig. 1;
Fig. 4 is an enlarged front view diagrammatically illustrating portions at which fin means and a base plate are to be joined together according to the present invention;
Fig. 5 is an enlarged front view diagrammatically illustrating in some detail a certain form with which fin means and a base plate are to be joined together according to the present invention;
Fig. 6 is an enlarged front view diagrammatically illustrating in some detail another form with which fin means and a base plate are to be joined together according to the present invention;
Fig. 7 is a perspective view of a liquid cooled heat sink to which the present invention has been applied;
Fig. 8 is a diagrammatic view showing a pair base plates and a coolant fluid transporting pipe before they are joined together in assembling the heat sink according to the present invention;
Fig. 9 is an enlarged view showing the parts before the base plates are fitted and joined together in assembling the heat sink according to the present invention;
Fig. 10 is an enlarged view of the parts after the base plates are fitted and joined together for the heat sink assembled in accordance with the present invention;
Fig. 11 is a front view showing an improved heat sink according to the present invention;
Fig. 12 is a perspective view of two of fin member units which are to be joined with a base plate in assembling the heat sink according to the present invention;
Fig. 13 is a perspective view of the base plate before it is joined with the fin member in accordance with the present invention;
Fig. 14a is a top plan view of the heat sink, showing coolant fluid passage prior to the upstanding bend machining process;
Fig. 14b is a top plan view of the heat sink, showing coolant fluid passages after the upstanding bend machining process is carried out in accordance with the present invention;
Figs. 15a and 15b are partial front views of the heat sink, showing a unit fin before and after it is subjected to an alternate bending process in accordance with the present invention;
Figs. 16a and 16b are partial front views of the heat sink showing how the heat sink is assembled in accordance with the present invention;
Fig. 17 is a front view showing an improved heat sink according to the present invention;
Fig. 18 is a perspective view of the heat sink just mentioned;
Figs. 19a and 19b are partial front views showing a fin member unit before and after it is provided, in addition to a flat straight plate, with a flat, bent and then flat plate in accordance with the present invention;
Fig. 20 is a perspective view showing an example of the cooling of the heat sink according to the present invention;

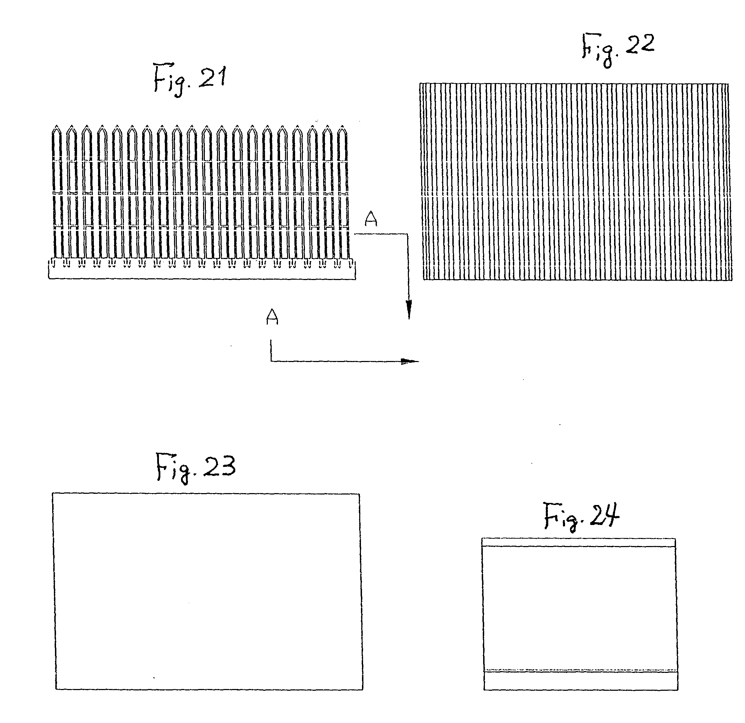

Fig. 21 is a front elevational view of a heat sink in a first design according to the present invention;
Fig. 22 is a top plan view of the heat sink in the said first design according to the present invention;
Fig. 23 is a bottom plan view of the heat sink in the said first design according to the present invention;
Fig. 24 is a right hand side elevational view of the heat sink in said first design according to the present invention;

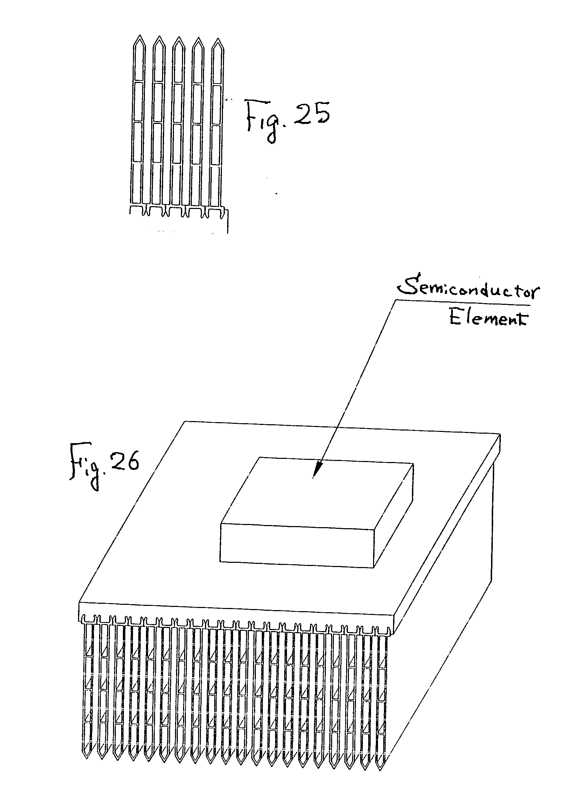

Fig. 25 is an enlarged view of a portion shown by arrows in Fig. 21;
Fig. 26 is a perspective view showing an exemplary state of use of the heat sink in the said first design according to the present invention;

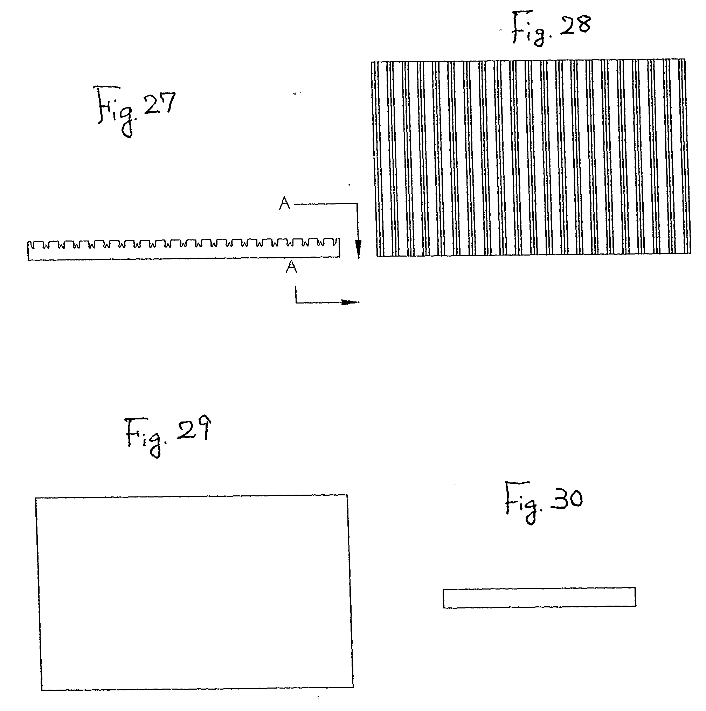

Fig. 27 is a front elevational view of the base plate of a heat sink in a second second design according to the present invention;
Fig. 28 is a top plan view of the base plate of the heat sink in the said second design according to the present invention;
Fig. 29 is a bottom plan view of the base plate of the heat sink in the said second design according to the present invention;

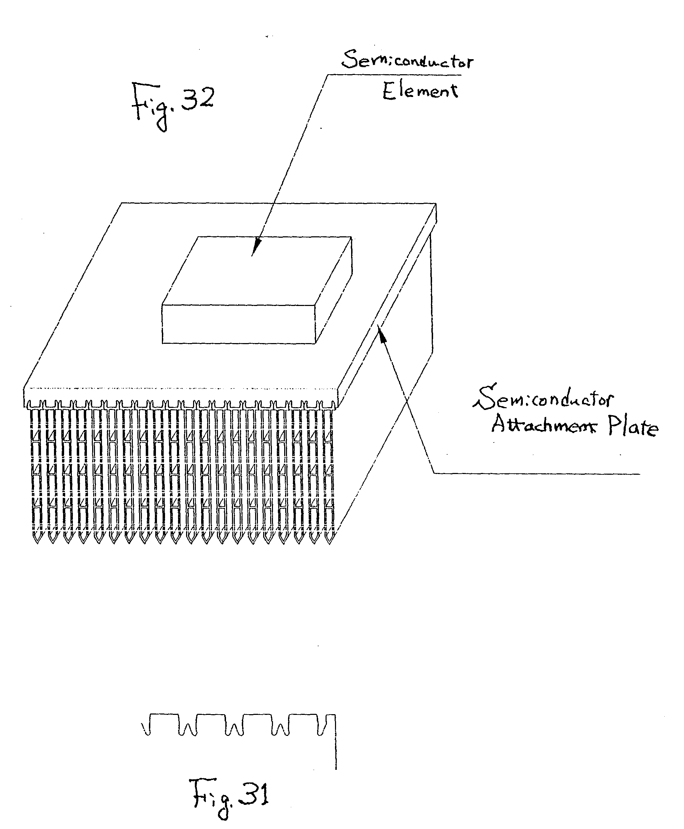

Fig. 30 is a right hand side elevational view of the the bottom plate of the heat sink in said second design according to the present invention;
Fig. 31 is an enlarged view of a portion shown by arrows in Fig. 27;
Fig. 32 is a perspective view showing an exemplary state of use of the heat sink in the said second design according to the present invention;

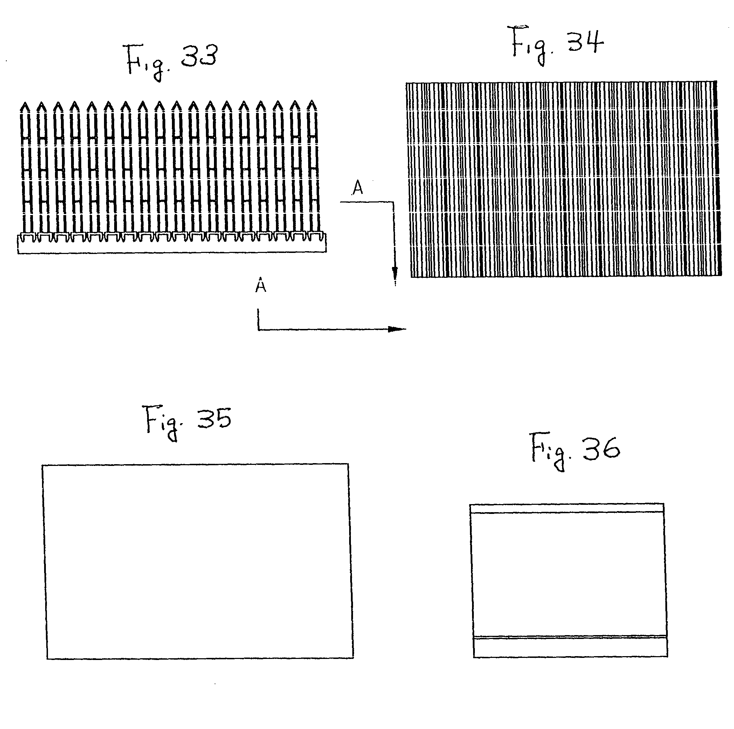

Fig. 33 is a front elevational view of a heat sink including a fin member and base plate in a third design according to the present invention;
Fig. 34 is a top plan view of the heat sink in the said third design according to the present invention;
Fig. 35 is a bottom plan view of the heat sink in the said third design according to the present invention;
Fig. 36 is a right hand side elevational view of the heat sink in said third design according to the present invention;

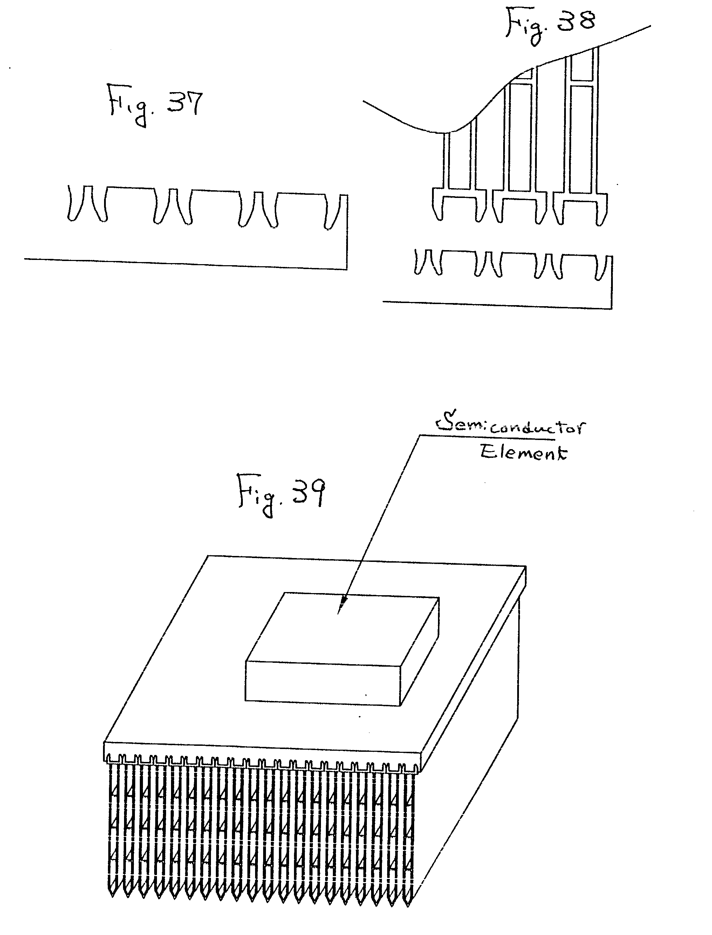

Fig. 37 is an enlarged view of a portion of the base plate shown by arrows in Fig. 33 before said fin member is joined with the base plate;
Fig. 38 is an enlarged view showing a state before said fin member is joined with the said base plate in the said third design according to the present invention; and
Fig. 39 is a perspective view showing an exemplary state of use of the heat sink in the said third design according to the present invention.

Hereinafter, a suitable embodiment of the present invention with respect to a heat sink and a method of assembling a heat sink as well as a method of joining together a pair of extruded materials each having a high thermal conductivity and a product made by the method will be set forth with reference to the accompanying drawings hereof.

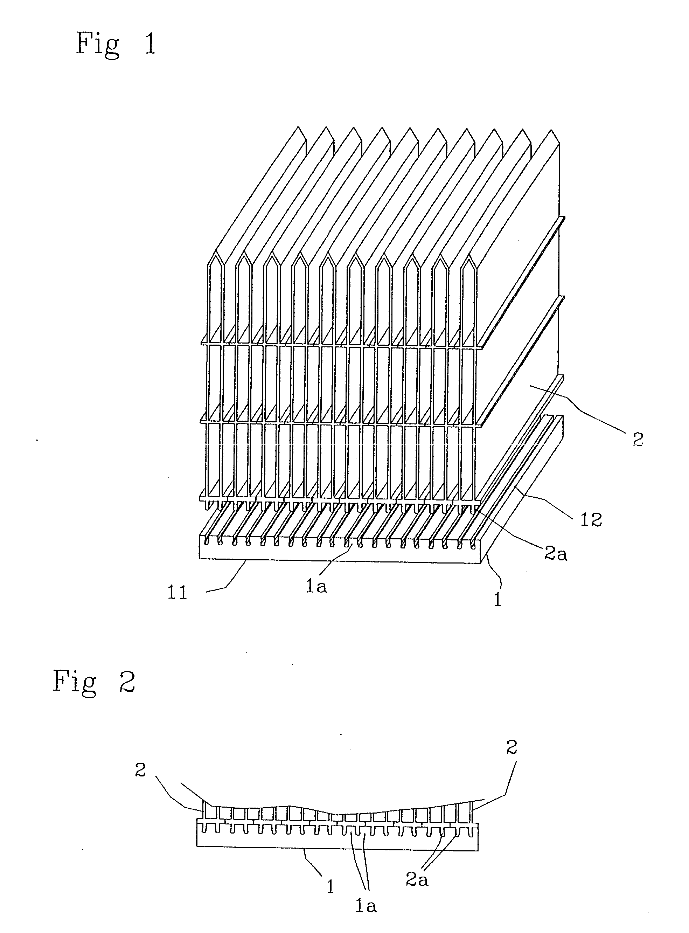

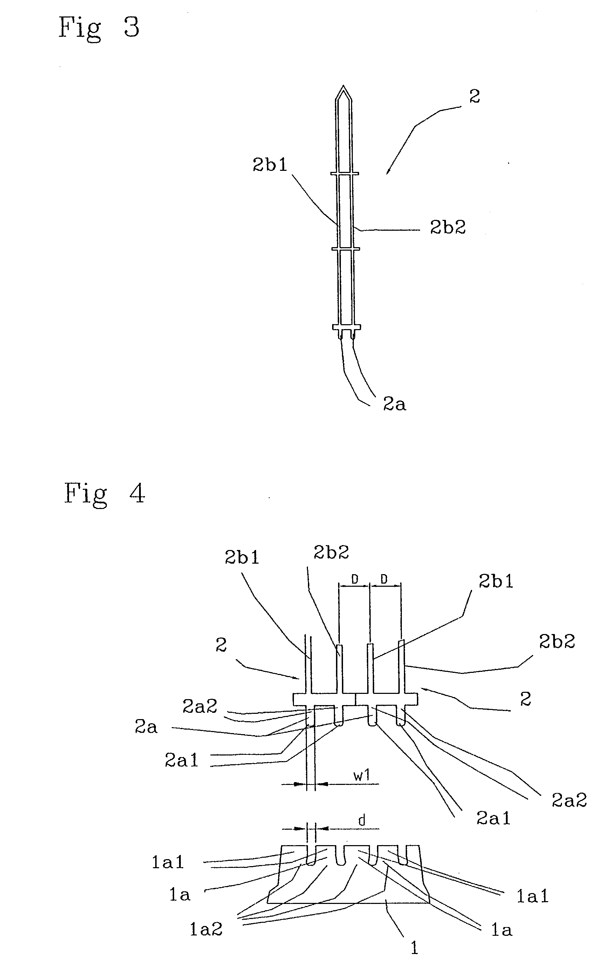

Referring now to Figs. 1 to 4, numeral 1 represents a base plate having a surface 11 to which a heat emitting (generating) element (not shown) is attached; and numeral 2 designates fin means whose assembly is jointed to a surface 12 which is opposed to the attachment surface 11 for the heat generating element of the base plate 1. The base plate 1 and the fin means 2 are, here, each constructed of an extruded member that is composed of a material which is high in thermal conductivity such as, for example, aluminum. The fin means 2, as shown in Fig. 3, is constructed as having, at one end thereof, a plurality of projecting portions 2a which constitute fastening portions for joining the fin means 2 to the base plate 1 and as having side plates 2b1 and 2b2 with which small compartments are formed so as to form a radiation fin unit. The side plates 2b1 and 2b2 are shown as having an interspacing D. The fin assembly is constituted by a plurality of fin means 2 which are to be joined to the base plate 1 in order to acquire a predetermined heat radiating property for a heat sink.

As shown in Fig. 4, each projecting portion 2a at the end of each fin means 2 which extends in a vertical direction is constructed to have a predetermined width w1 and is formed at its front end with a positioning portion 2a1 and at its root side with a caulking portion 2a2. On the other hand, the base plate 1 is formed with a plurality of projecting portions 1a each of which is formed with its forward end with a positioning portion 1a1 and at its rood side with a calking portion 1a2, with the caulking portion 1a2 being inclined with an angle relative to a vertical direction. The positioning portion 2a1 is formed to have a rounded forward end whereas a recessed portion 2a between two adjacent projecting portions 1a of the base plate 1 is formed to have a rounded bottom. Also, the width w1 of each projecting portion 2a of the fin means 2 is made identical to, or slightly larger than, a spacing or the width d of the recessed portion between two adjacent projection portions 1a of the base plate 1. Furthermore, the spacing between two adjacent projecting portions 2a of the fin means 2 is made identical to, or slightly smaller than the width of each projecting portion 1a of the base plate 1.

In order that a pressure applied downwardly from the fin means 2 or applied upwards from the base plate 1 may, when they are fastened together, be converted to a force of fastening between the fin means 2 and the base plate 1 with certainty, the positioning portions 1a1 of the base plate 1 and the positioning portions 2a1 of the fin means 2, when the fin means 2 and the base plate 1 are fittedly inserted into each other, have a role for retaining their verticality.

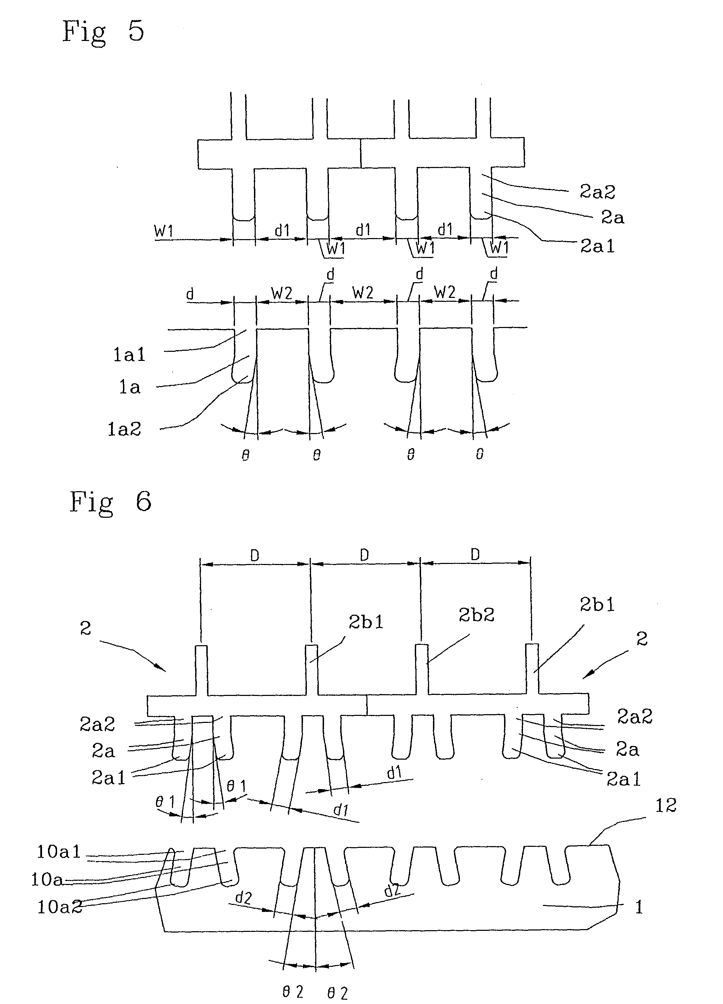

Referring to Fig. 5, numeral 1a is shown to designate a recessed portion formed between two adjacent projecting portions of the base plate 1 and having the width d. Furthermore, the interspacing between two adjacent projecting portions 2a of the fin means 2 is shown as having a width d1 whereas a projecting portion between two adjacent recessed portions 1a of the base plate 1 is shown as having a width w2. In addition, the aforementioned angle, here, at the caulking portion 1a2 of each recessed portion 1a of the base plate 1 is shown by θ, each recessed portion 1a having a positioning portion 1a1. Note also that two adjacent recessed portion are shown as being inclined (with the angle θ ) in opposite direction at their caulking portions 1a1.

An explanation will now be given with respect to a method of assembling a heat sink that is constructed as mentioned above.

Prior to the assembling, it will be noted that the surface of fin means 2 and the surface of the base plate 1, which are typically each made up of an extruded aluminum material, have been each oxidated to have an oxide film of some degree of thickness formed thereon.

In the stage of assembling, by utilizing, for example, a general purpose hydraulic press or the like and a simple jig in a combination, the projecting portions 2a at the front end of each fin means 2 are fittedly inserted forcibly into recessed portions 1a between the individual projecting portions of the base plate 1 under a pressure amounting to several tens tons that is applied in a short period of time.

At the time of pressure-inserting the fin means 2 into the base plate 1, since the width d of each recessed portion 1a of the base plate 1 is made identical to, or slightly smaller than, the width w1 of each projecting portion 2a of the fin means 2, the interspacing d1 between two adjacent projecting portions 2a of the fin means 2 is made identical to, or slightly smaller than, the width w2 of each projecting portion between two adjacent recessed portions 1a of the base plate 1, the positioning portion 2a1 of each projecting portion 2a is formed to have a rounded forward end and each recessed portion 1a is formed to have a rounded bottom, it can be seen that if a large pushing pressure is applied downwardly from the fin means 2, the positioning portion 2a1 of each of the projecting portions 2a of the fin means 2 will first be introduced into the positioning portion 1a1 of each of the recessed portions 1a of the base plate 1 and will then be introduced into the caulking portions 1a2 of each recessed portion 1a of the base plate 1. At this time, since the caulking portions 1a2 of the recessed portions 1a of the base plate 1 are each inclined with the slight angle θ relative to the vertical direction, it can be seen that the positioning portion 2a1 of each projecting portion 2a of the fin means 2 which is introduced into a corresponding recessed portion 1a of the base plate 1 will be inserted fittedly into the caulking portions 1a2 of the recessed portions 1a of the base plate 1 while being bent in conformance to the inclination of these caulking portions 1a2.

At this time, since the width w1 of each of the projecting portions 2a and the width w2 of each of the projecting portions 1a are made identical to, or slightly larger than, the spacing d between the adjacent two projecting portions 1a and the spacing D between the adjacent two projecting portions 2a, respectively, it should be noted that a phenomenon called "dragging" will be generated between the respective external surfaces of the projecting portions 1a and 2a.

More specifically, with the external surface of each of the projecting portions 2a of the fin means 2 and the internal surface of each of the recessed portions 1a of the base plate 1 being in contact with each other, it can be seen that a force of friction will be generated between these surfaces and, for the reason of this frictional force, the oxide film that has been formed on each of the respective external surfaces of the projecting portions 1a and the oxide film that has been formed on each of the respective internal surfaces of the recessed portions 2a will be scraped away from each other and a dragging action will take place. As a result, an extremely intimate joining state will be established between each of the respective positioning portions 2a1 of the projecting portions 2a and a corresponding one of the respective caulking portions 1a2 of the recessed portions 1a on the one hand and between each of the respective positioning portions 1a1 of the recessed portions 1a and a corresponding one of the respective caulking portions 2a2 of the projecting portions on the other hand. Accordingly, with the projecting portions 2a and the corresponding recessed portions 1a being intimately joined, it can been seen that both the thermal conductivity and the electrical conductivity between the fin means 2 and the base plate 1 will be extremely enhanced.

It should also be noted that each portion of joining between the fin means 2 and the base plate 1 which are pressure inserted into each other will give rise to a stress in their contacting horizontal direction due to the pressure applied in the vertical direction, hence yielding their fastening result with a greater certainty.

Since the positioning portion 2a1 of each projecting portions 2a, when pressure inserted, is forcibly bent with the angle θ of the caulking portion 2a2 of the corresponding recessed portion relative to the vertical direction, it should also be noted that a work-hardening effect will be produced there, thereby giving rise to the fastening result with a greater certainty.

Thus, a heat that is generated from a heat generating element will be transferred from the base plate 1 via the joining surface established between the fin means 2 and the base plate 1 as mentioned above to the fin means 2. The fin means 2 will then act to take away the heat transferred from the base plate 1 by virtue of an air flow from a fan (not shown) that is attached to the heat sink assembly.

Whilst there is no problem with respect to the joining due to the dragging action between the fin means 2 and the base plate 1 if it is effected as mentioned above, it should be noted that in a case where the fin means 2 and the base plate 1 are each constructed of an extruded material, it differs from a cut material and includes a distortion therein that has be produced in an extrusion operation. Then, the fin means 2 and the base plate 1 might not be joined owing to the "dragging" action alone with stability. Even in such a case, it should be noted that a work hardening effect will here take place based on a plastic deformation at a forcibly bent portion (i. e. the forward end of a positioning portion 2a1) when the fin means 2 and the base plate 1 are joined together and will affect a force of joining the fin means 2 to the base plate 1 together. Note here that the force of joining between the fin means 2 and the base plate 1 is directly related to a thermal conductivity at the interface between them. More specifically, this portion has a role to compensate for an inconsistency in the performance of a heat sink that results from an inconsistency in size of products. It should also be noted that even in a case where the oxide film that is produced on the external surface of each of the projecting portions is thick, thus making it impossible to develop a full dragging state, a stress at the joining surface that is produced by the pressure applied there will be capable of enhancing the thermal conductivity there.

Also, it should be noted that whilst the fin means 2 and the base plate 1 is brought into a joining state under the dragging action at the portions of the projecting portions when pressure inserted, it is also possible to carry out a preliminary step to remove an oxide film at a portion to be joined, that is, upon the external surface of each of the projecting portions by using a wire brush or the like prior to the pressure insertion. Thus, whilst the present invention enables an oxide film upon the external surface of each of the projecting portions an an oxide film upon the internal surface of each of the recessed portions to be removed by the dragging action and hence essentially makes it unnecessary to employ the above mentioned preliminary step, thus having the effects of simplifying the method of assembling and lowering the manufacturing cost, it is still possible to incorporate the above mentioned preliminary step in a case where the scraping of the oxide film by way of the dragging action can only be performed insufficiently.

It should further be noted that whilst in an example as mentioned above, the positioning portion of each projecting portion is formed to have a rounded forward end, such an end configuration is not an absolute limitation but it may, for example, be wedge shaped.

Next, Fig. 6 shows a modified embodiment of a section where the fin means 2 and the base plate 1 are to be joined together to constitute a heat sink according to the present invention.

In this embodiment, a projecting portion 2a at the front end of each fin means 2 is formed to have a predetermined width d1 and is constructed with a forward end portion 2a1 and a root end portion 2a2. It is seen that the root end portion 2a2 is formed to extend in a vertical direction and the forward end portion 2a1 is formed so as to be inclined with a small angle θ 1 relative to the vertical direction. It is seen that the forward end portion 2a1 is formed to have a rounded forward end.

On the other hand, the attachment surface 12 of the base plate 1 is formed with such a plurality of recessed portions 10a as corresponding to a plurality of projecting portions 2a of the fin means 2. Such a recessed portion 10a is formed to have a width d2 that is slightly smaller than the width dl of each projecting portion 2a and to linearly extend in a direction that is inclined with an angle θ 2 with respect to the vertical direction. It is seen that the angle θ 2 is set to be greater than the angle θ 1. It is also seen that the recessed portion 10a has a depth that corresponds to the length of the projecting portion 2a, and has a bottom which conforms to the configuration of the forward end of the projecting portion 2a.

In the stage of assembling, by utilizing, for example, a general purpose hydraulic press or the like and a simple jig in a combination, portions of the projecting portions 2a of each fin means 2 are fittedly inserted forcibly into the corresponding recessed portions 10a of the base plate 1, respectively, under a pressure amounting to several tens tons that is applied in a short period of time.

At the time of pressure-inserting the fin means 2 into the base plate 1, since the width d1 of each of the projecting portions 2a of the fin means 2 is made slightly larger than the width d2 of each recessed portion 10a of the base plate 1 and the forward end portion 2a1 of each projecting portion 20a is formed to have a rounded forward end while the corresponding recessed portion 10a is formed to have a rounded bottom complementary thereto, it can be seen that if a large pushing pressure is applied downwardly from the fin means 2, the forward end portion 2a1 of each of the projecting portion 2a of the fin means 2 will be introduced into a corresponding recessed portion 10a of the base plate 1. At this time, since the the recessed portions 10a are each inclined with the angle θ 2 relative to the vertical direction, it can be seen that the forward end portion 2a1 and the root end portion 2a2 of each projecting portion 2a of the fin means 2 which is introduced into a corresponding recessed portion 10a of the base plate 1 will be inserted fittedly into the recessed portion 10a while being bent in conformance to the angle of inclination θ 2 thereof.

At this time, since the width d1 of each of the projecting portions 2a is made greater than the width d2 of each of the recessed portions 10a, it should be noted that a phenomenon called "dragging" will be generated between the external surface of each of the projecting portions 2a and the internal surface of each of the recessed portions 10a. More specifically, with the external surface of each of projecting portions 2a of the fin means 2 and the internal surface of each of the recessed portions 10a of the base plate 1 being in contact with each other, it can be seen that a force of friction will be generated between these surfaces and, for the reason of this frictional force, the oxide film that has been formed on each of the respective external surfaces of the projecting portions 2a and the internal surface of each of the recessed portions 10a will be scraped away and the dragging will take place. As a result, an extremely intimate joining state will be established between these surfaces. Accordingly, with the projecting portions 2a and the recessed portions 10a being intimately joined, it can been seen that both the thermal conductivity and the electrical conductivity between the fin means 2 and the base plate 1 will be extremely enhanced.

It should also be noted that each portion of joining between the fin means 2 and the base plate 1 which are pressure inserted into each other will give rise to a stress in their contacting horizontal direction due to the pressure applied in the vertical direction, hence yielding their fastening result with a greater certainty.

Since the forward end portion 2a1 of each of the projecting portions 2a of the fin means, when pressure inserted, is forcibly bent with the angle θ 2 of each recessed portion 10a of the base plate 1 relative to the vertical direction, it should also be noted that a work-hardening effect will be produced there, thereby giving rise to the fastening result with a greater certainty.

Whilst an explanation has been given with respect to the various embodiments of the present invention, it will be understood that these embodiments are in no way intended to limit the present invention and a variety of modifications thereof can be made within the spirit and scope of the present invention.

For example, it should be noted that in the embodiment shown in Fig. 6, whilst the projecting portions 2a are formed on the side of the fin means 2 and the recessed portions 10a are formed at the side of the base plate 1, it is also possible to form the recessed portions at the side of the fin means 2 and the projecting portions on the side of the base plate 1.

It should further be noted that in the various embodiments set forth in the foregoing, the configuration and the number of the projecting portions and the recessed portions can suitably be altered depending upon the magnitude of the pressure that is applied when the fin means 2 and the base plate 1 are pressure inserted into each other.

According to a method of assembling a heat sink that is provided in accordance with the present invention, it will now become apparent that neither a brazing facility nor any expensive dedicated machine for the purpose of caulking is required and a heat sink can readily be manufactured with a combination of a general purpose press or the like and a simple jig.

Also, according to a heat sink that is provided in accordance with the present invention, it will now become apparent that its thermal conductivity is sharply enhanced by the intensive action of rubbing a pair of the joining surfaces of the base plate and the fin means together which action is generated when they are fittedly inserted forcibly into each other and which acts to scrape away the oxide films previously formed thereon and thereby to refresh these joining surfaces and by rendering the refreshed surfaces in a joining state by way of dragging.

Also, with an extrusion technique and a step of heat treatment as required taken into consideration, in a variety of preliminarily varied situations including a case where fully refreshed surfaces may not be realized because of the thickness of such an oxide film and a case where the precision of the extrusion required is varied more or less, it will now become apparent that the present invention enables the fin means and the base plate to be firmly fastened with a greater certainty.

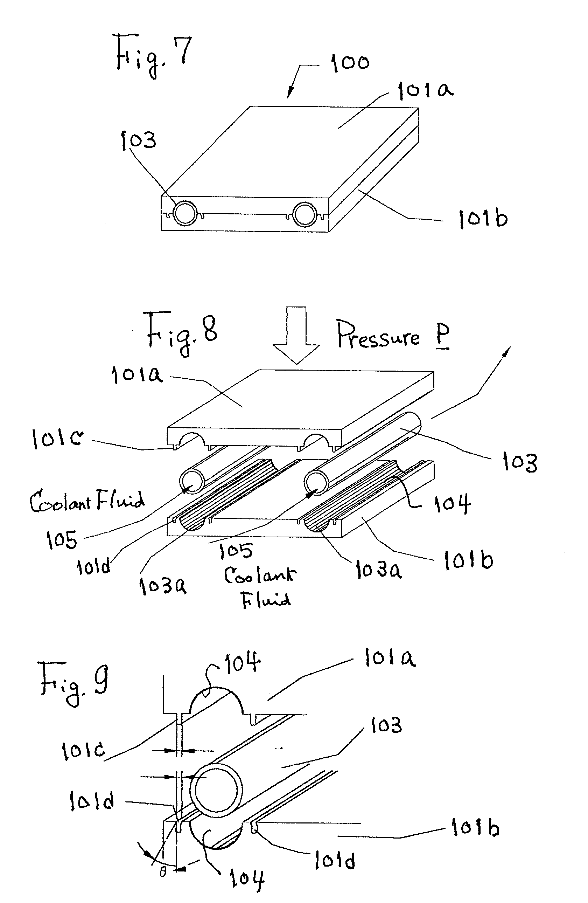

Now, prior to discussing a further embodiment of the present invention shown in Figs. 7 to 10, it should be noted that in a case where an exothermic (heat emitting) element such as a diode and a thyristor is to be cooled with a liquid coolant heat sink, a cooling fluid transporting tube has hitherto been provided therein or therewith. It is noted that with a cooling fluid transporting tube, which is typically constituted of such as a metal as copper, that is corrosion resistant, and such a metal as aluminum providing a surface on which a heat emitting element may be mounted, a brazing or a caulking could be a possible way of joining the two metals together. Under such circumstances in the field of a heat sink, there have hitherto been encountered the problems or disadvantages that the brazing method is characterized by a low productivity and an increased production cost and the caulking method is characterized by a poor fitting of the two metals together.

Accordingly, the present embodiment of the invention resides in resolving the above mentioned disadvantages in the prior art and providing a liquid cooled heat sink that is inexpensive and excellent in the heat emitting effect.

The present invention can be effectively implemented in producing a heat sink for cooling exothermic (heat emitting) element such as a transistor or thyristor in the field of electrical industry.

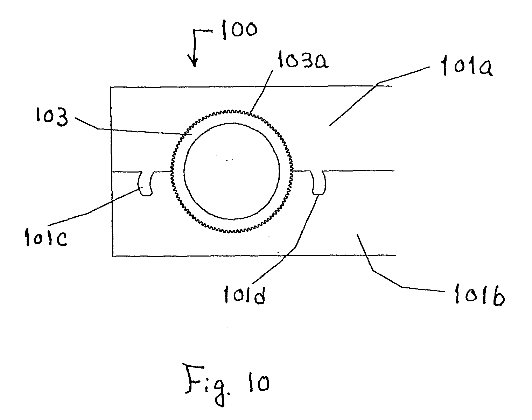

Fig. 7 is a perspective view of an improved liquid cooled heat sink 100 for use in the implementation of the present invention; Fig. 8 is a view showing a procedure in which the liquid cooled heat sink 100 is assembled; Fig. 9 is an enlarged view of certain parts prior to the joining process; and Fig. 10 is an enlarged view showing the the parts posterior to the joining process.

Fig. 8 represents a state before the liquid cooled heat sink 100 is assembled in accordance with the present invention. A pair of base members 101a and 101b which are each made up of an extruded material to allow a exothermic (heat emitting) element to be attached thereto and which are to have a pair of coolant fluid transporting pipe 103 fitted between them are each formed for this purpose with a groove 104 therein, which is in turn formed with a multiplicity of small projecting stripes 103a. The said base members 101a and 101b are also formed on one of them with projecting stripes 101c and in the other of them with recessed stripes 101d which correspond to the projecting stripes 101c, respectively, so that they in each individual pair thereof may be forcibly fitted together under a pressure P that is applied externally as shown. Each of the said projecting stripes 101c and the said recessed stripes 101d is wider than each of the said small projecting stripes 103a as shown. It should be noted here that when the said projecting stripes 101c and the recessed stripes 101d corresponding thereto are forcibly fitted together under the external pressure P to join the said base members 101a and 101b together, the surface of the said coolant fluid transporting pipe 103 that is sandwiched between them will be formed (notched) thereon with projecting stripes corresponding to the said narrower projecting stripes 103a on the groove 104 surfaces of the base members 101a and 101b.

Fig. 9 represents an enlarged view of the parts before the said base members 101a and 101b are joined together. It should be noted that the width d of a said projecting stripe 101c formed on the said base member 101a as shown is sized to be substantially equal to or greater than the width d1 of a said recessed stripe 101d corresponding thereto formed on the said base member 101b as shown. Also, a said recessed stripe 101d as shown is shaped to have a changing angle θ. For these reasons, it has been found that by permitting the said projecting stripes 101c to be forcibly inserted under the pressure P into the said recessed stripes 4a, respectively, the said base members 101a and 101b are joined together with a greater fastening force since each of the projecting stripes 101c is forcibly bent and plastically deformed under the pressure P to yield a work hardening effect and is so pressure inserted forcibly into the corresponding recessed stripe 101d.

Fig. 10 represents an enlarged view of the parts after the said two base plates 101a and 101b and the said coolant fluid transporting pipe 103 are fitted and joined together. It is seen that the surface of the said coolant fluid transporting pipe 103 is now provided (notched) with the narrower projecting stripes corresponding to those 103a which are originally applied to the said base members 101a and 101b while the latter two are fittedly joined together with the said wider projecting stripes 101c and recessed stripes 101d. Thus, it ensues that the joining strength of the said base members 101a and 101b and the said pipe 103 as well as their contact surfaces is largely increased so that a heat sink with an excellent cooling effect can be produced.

At this point it should be noted that a heat sink mounted to a microprosessor or the like and designed to cool the same must have a degree of freedom in a cooling path. For this reason, a heat sink has so far been provided by mounting a pin fin on a base plate or been prepared in the prior art by notching each of a pair of extruded members with a series of stripes and then joining those members together. It has been recognized, however, that either of these methods is problematical in terms of its production cost and its resultant cooling power.

Accordingly, a further embodiment of the present invention shown in Figs. 11 to 16 resides in providing an inexpensive and yet high performance heat sink 200 that is prepared by applying an upstanding bend machining process to a fin member 202 to be attached to a base plate 201 to give a desired degree of freedom in its cooling path direction and, then, when the said fin member 202 is fittedly attached to the base plate 201, utilizing a stress and a work hardening effect that is developed at the interface between them.

The present embodiment as well as the others of the invention can be effectively implemented in providing a heat sink for cooling a microprocessor or the like contained primarily in a computer and a server.

Fig. 11 is a front view of the improved heat sink 200 according to the present invention in which the fin member 202 as well as the base plate 201 to which a heat emitting element (not shown) is to be attached appears.

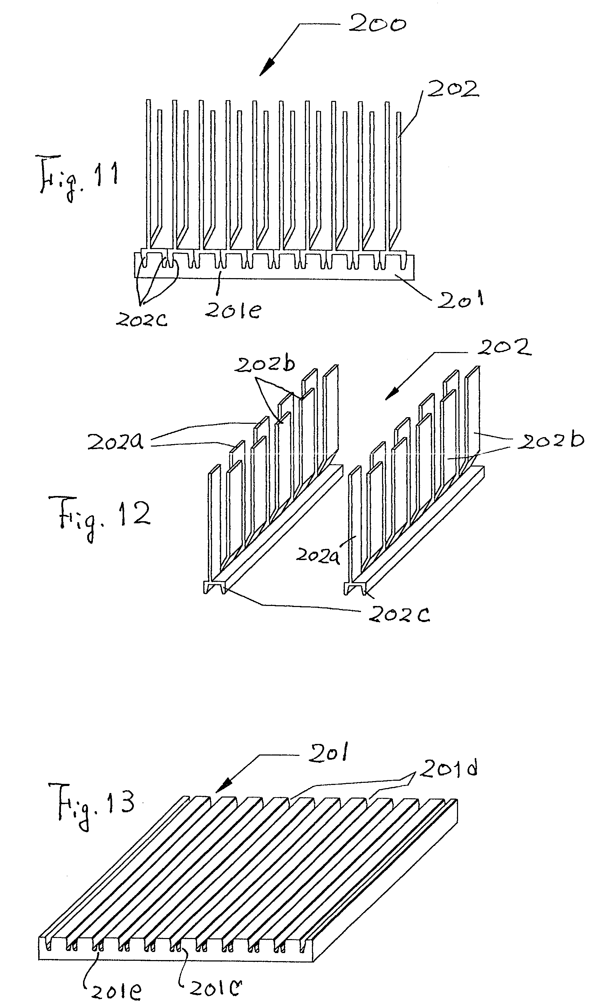

Figs. 12 and 13 are perspective views of the said fin member 202 and the said base plate 201, respectively, before they are joined together.

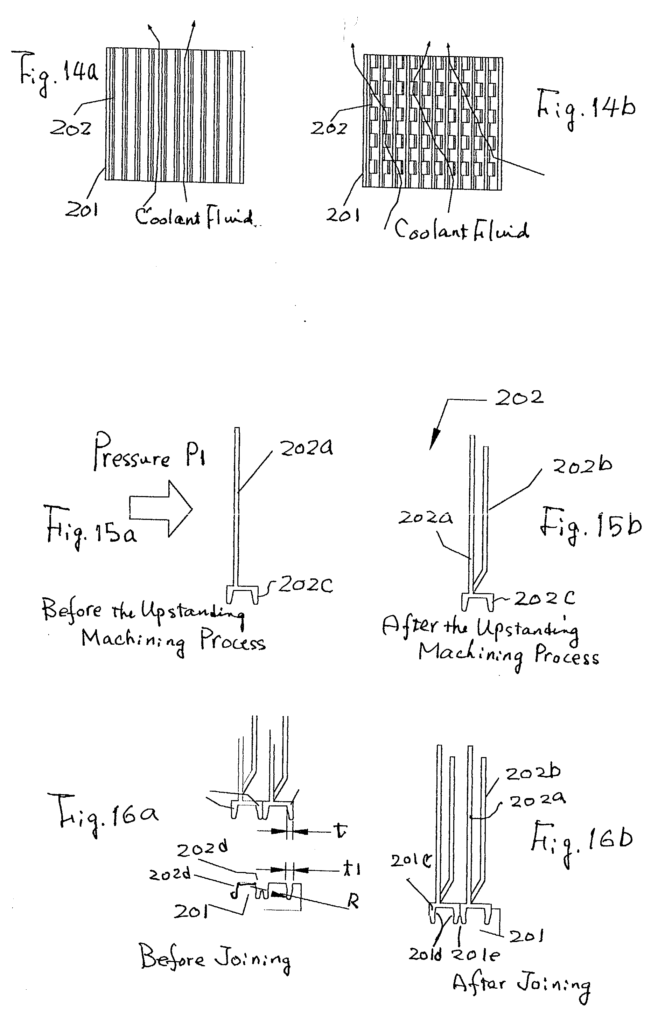

Figs. 14a and 14b represent top plan views showing the improved heat sink 1before and after the fin member 202 is subjected to an alternate bending process. It is shown that by applying the alternate bending process to the fin member 202, the coolant fluid flow that was mono-directional prior to the alternate bending process is given a desired degree of freedom posterior thereto, and then is rendered multi-directional.

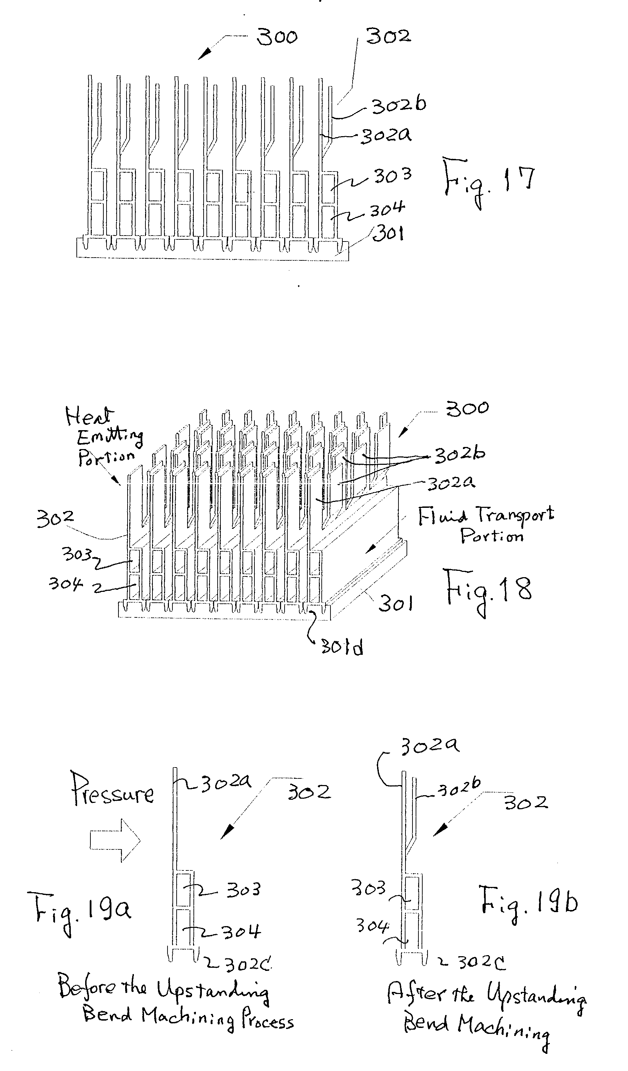

Figs. 15a and 15b represent partial front views showing a unit fin 202a before and after it is subjected to the alternate bending process. It is shown that the unit fin 202a which was simply upstanding or straight initially is bent into a form 202b by applying a pressure P1 thereto with a press or the like machine so that the fin member 202 may eventually have both simply upstanding or straight flat fins 202a and flat, bent and then upstanding or straight flat fins 202b which are alternately arranged.

Figs. 16a and 16b illustrate how the fin member 202 and the base plate are joined together at their interface, thus in a manner as mentioned previously. It should be noted that the said fin member 202 has projecting portions (stripes) 202c each of which is sized to have its width t that is slightly larger than the width t1 of each of recessed portions (stripes) 201d which are formed on the said base plate 201 so that a said projecting portion 202c may be forcibly inserted and fitted into a said recessed portion 201d corresponding thereto under the pressure P1. It is shown here that an intermediate pair of adjacent projections 202c when forcibly inserted under pressure P1 into a said recessed portion 201d corresponding thereto is divided from each other with a small projection 201e formed in a said recessed 201d on the base plate 201 so as to be firmly lodged therein with an increased fastening strength between the fin member 202 and the base plate 201. Also, it may be noted that the bottom of each of the said recessed portions 202d is rounded with a radius R. Thus, when the said projecting portions 202c are forcibly inserted into the said recessed portions 201d under the pressure P1, the foregoing construction allows a work hardening effect to be enhanced thereof and combined with an internal stress created therein, thus permitting the said fin member 202 and the base plate 201 to be joined together with a further increased fastening strength.

Before discussing another embodiment if the present invention as shown Figs. 17 to 20, it should be noted that whilst a heat sink in the prior art for cooling a transistor, a thyristor and so forth has been manufactured from extruded members, its heat emitting area has been determined by its cross sectional configuration. For this reason, it has hitherto been not possible to drastically change the heat emitting area of a cooling fluid transport portion and a heat emitting portion of the said heat sink.

Accordingly, the further embodiment of the present invention shown in Fig. 17 to 20 resides in providing an inexpensive, light weighted and yet high performance heat sink that is prepared by providing a fin section to be attached to a base plate with a cooling fluid transport portion and a heat emitting portion, the latter being comprised of a plurality of flat plates and a plurality of flat, bent and then flat plates, thereby increasing the heat emitting area of the said heat sink.

Figs. 17 and 18 show this improved heat sink 300 in which a base plate 301 to which a heat emitting element (not shown) is to be attached and a fin member 302 appear, the latter comprising a plurality of fin sections for emitting a heat that is transferred from the said base plate 301. The base plate 301 and each of the said fin sections 302 are made up of extruded members which are independent from each other, and are joined together under a pressure as previously set forth.

As shown in Fig. 18, the improved heat sink comprises: the base plate 301and a plurality of fin sections 302 each of which is provided with a hollow cooling fluid transport tubular portion 303, 304 and a heat emitting portion located above it and comprised of a plurality of flat straight plates 302a and a plurality of flat, bent and then flat plates 302b which are so formed by a press or the like machine. As shown, the said plurality of flat straight plates 302a and the said plurality of flat, bent and then flat plates 302b are arranged alternately.

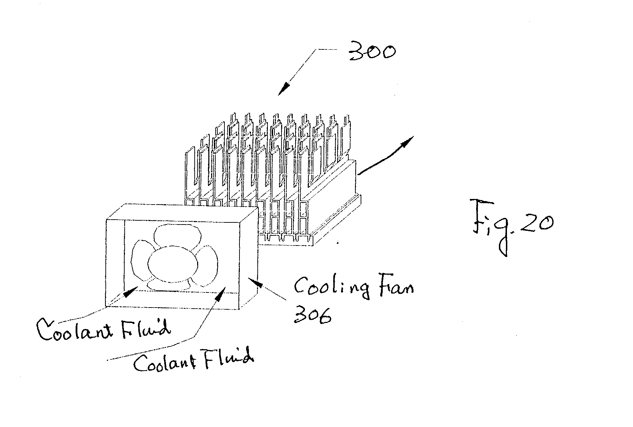

In a case where a heat emitting element (not shown) attached to the said base plate 301 is to be forcibly air cooled by a fan or the like, as shown in Fig. 20 the heat sink 300 will be cooled by a fan 306disposed ahead thereof in the Figure. Then, the cooling performance will tend to be the highest near the air 305 upstream and to become lower in the air 305 downstream above the base plate 301, thus making the heat distribution ununiform over the base plate 301. Thence, in order to lessen such ununiformity of the heat distribution, a heat emitting portion 302 that is comprised of a plurality of flat straight plates 302a and a plurality of flat, bent and then flat plates 302b which are alternately arranged is provided towards the top portion as shown in the heat sink 300 to increase the heat emitting area therein. Then, not only is this arrangement capable of preventing the said extreme ununiformity of the heat distribution, but also it is capable of drastically enhancing the entire cooling performance. Also, since the heat emitting area is increased without requiring any additional material, an inexpensive, light weighted and yet high performance heat sink here results.

Accordingly, an inexpensive, light weighted and yet high performance heat sink can be manufactured by adding at the top of the fin in the heat sink in the prior art a unique heat emitting portion comprised of a plurality of flat straight plates and a plurality of flat, bent and then flat plates which are arranged alternately.

In sum, most generally it has now become apparent according to the present invention that the two members of a high thermal conductivity will be joined together at their respective projecting and recessed portions primarily by both the dragging action and the work hardening which would take place there and that even in a case where each oxide film is so thick that a sufficient dragging state may not be brought about, the thermal conductivity at their interface can still be enhanced by means of a stress as mentioned above which would be created by the pressure applied.

Still more, it should be noted that whilst the projecting portions 140 are each shown as having a rounded forward end, they may wholly or in part be formed each with a wedge shaped forward end.

According to the present invention, a pair of members each having a high thermal conductivity is joined together, without requiring a brazing facility and an expensive dedicated machine having the ability to caulk but by using only a general purpose hydraulic press and a simple jig in a combination, to yield an excellently joined product having a superior thermal conductivity.

Also, according to the present invention, when the respective joining surfaces of a pair of such members, e. g. excluded metallic materials, are fitted with each other, there doest it result that they are intensively abraded mutually to the extent that an oxide film as formed of each of the joining surfaces are scraped away to allow a refreshed substrate surface of one of the joining surfaces and a refreshed substrate surface of the other to be exposed, with the refreshed substrate surfaces being subjected to a dragging action so as to be brought into a tightly joined state, thereby enhancing the thermal conductivity at the joined interface

Also, with the extruding technique and the heat treatment step required taken into consideration, even in a variety of preliminarily varied situations including a case where an oxide firm as formed is so thick that a fully refreshed substrate surface may not develop, or a case where the precision of the extrusion required may be varied more or less, it will now become apparent that the present invention enables a pair of members as described to be joined together with a greater certainty.

While the present invention has hereinbefore been described with respect to a certain illustrative embodiment thereof, it will readily be appreciated by a person skilled in the art to be obvious that many alterations thereof, omissions therefrom and additions thereto can be made without departing from the essence and the scope of the present invention. Accordingly, it should be understood that the present invention is not limited to the specific embodiments thereof set out above, but includes all possible embodiments thereof that can be made within the scope with respect to the features specifically set forth in the appended claims and encompasses all equivalents thereof.

## Claims

1. A method of joining together a pair of extruded members each having a high thermal conductivity, the method comprising the steps of:
forming a first of the two thermally high conductivity members, at a joining surface thereof, with at lease either of a plurality of projecting portions and a plurality of projecting portions and recessed portions;
forming a second of said two members, at a joining surface thereof, with at least either of a plurality of recessed portions each of which corresponds to a selected one of said projecting portions and a plurality of projecting portions each of which corresponds to a selected one of the recessed portions of said projecting and recessed portions of said first member;
sizing a width of a said projecting portion so as to be substantially identical to, or, preferably, greater than, a width of a said recessed portions; and
forcibly inserting under pressure each of said projecting portions of one of said two members into each of said recessed portions that corresponds thereto, of another of said two thermally high conductivity members to induce a plastic deformation in each of said members.

2. A method of joining together a pair of extruded members each having a high thermal conductivity, the method comprising the steps of:
forming a first of the two thermally high conductivity members, at a joining surface thereof, with at least either of a plurality of projecting portions and a plurality of projecting and recessed portions;
forming a second of said two members, at a joining surface thereof, with at least either of a plurality of recessed portions each of which corresponds to a selected one of said projecting portions and a plurality of projecting portions each of which corresponds to a selected one of the recessed portions of the projecting and recessed portions of said first member;
providing each of at least some of said projecting portions and said recessed portions with a portion which is inclined with a given angle;
sizing a width of a said projecting portion so as to be substantially identical to, or, preferably, greater than, a width of a said recessed portion;
forcibly inserting under pressure each of said projecting portions of one of said two members into each of said recessed portions that corresponds thereto, of another of said two members;
in a stage in which said projecting portions are forcibly inserted under pressure into said corresponding recessed portions, dynamically affecting areas of at least some of said projecting portions and said recessed portions with such portions each as inclined with said given angle, thereby plastically said areas; and,
as a result of the plastic deformation of said areas, effecting a work hardening thereof so as to enhance a tightness of fastening between said two thermally high conductivity members.

3. A method of joining together a pair of extruded members each having a high thermal conductivity, the method comprising the steps of:
forming a first of the two thermally high conductivity members, at a joining surface thereof, with at least either of a plurality of projecting portions and a plurality of projecting and recessed portions;
forming a second of said two members, at a joining surface thereof, with at least either of a plurality of recessed portions each of which corresponds to a selected one of said projecting portions and a plurality of projecting portions each of which corresponds to a selected one of the recessed portions of said projecting and recessed portions of said first member;
providing each of at least some of said projecting portions and said recessed portions with a portion that is inclined with a given angle;
sizing a width of a said projecting portion so as to be substantially equal to, or, preferably, greater than a width of a said recessed portion;
forcibly inserting under pressure each of said projecting portions of one of said two members into each of said recessed portions that corresponds thereto, of another of said two members to induce a plastic deformation in each of the said members;
in a stage in which said projecting portions are forcibly inserted under pressure into said corresponding recessed portions, dynamically affecting areas of said at least some of said projecting portions and said recessed portions with such portions each as inclined with said given angle, thereby plastically deforming said areas;
and, as a result of the plastic deformation of said areas, effecting a work hardening thereof so as to enhance a tightness of fastening between said two thermally high conductivity members.

4. A method, as set forth in claim 1, claim 2 or claim 3, in which said members are each made up from a metallic material, the method further comprising the steps of:
providing each of at least some of said projecting portions and said recessed portions, which correspond to said recessed portions and said projecting portions in joining, with a portion that is inclined with a given angle; and
in a stage in which the said projecting portions are forcibly inserted under pressure into said corresponding recessed portions, developing a frictional action and a caulking action between each pair of at least some of said entering metallic projecting portions and at least some of said receiving metallic recessed portions which correspond thereto, developing an internal stress from a contraction and an expansion of each of said entering metallic projecting portions and each of said receiving metallic recessed portions, respectively, under said pressure, and joining said entering projecting portions and said receiving recessed portions together under a combined effect of said frictional and caulking actions and said internal stress under said pressure.

5. A method as set forth in claim 4 in which said two thermally conductivity members are constituted by a base plate and fin means, respectively, for a heat sink assembly.

6. A method of assembling a heat sink, where a base plate and a plurality of fin means disposed over the base plate are assembled together by inserting the fin means fittedly into the base plate, the method comprising the steps of:
forming said fin means and said base plate with a plurality of projecting portions and a plurality of recessed portions corresponding thereto, at a plurality of locations, respectively, at which said plurality of fin means and said base plate are to be fastened together, with said plurality of projecting portions, if formed over the said fin means, being adapted to be forcibly inserted fittedly under a pressure into the said plurality of recessed portions, if formed over the said base plate and said plurality of projecting portions, if formed over said base plate, being adapted to be forcibly inserted fittedly under the pressure into said plurality of the corresponding recessed portions, if formed over said fin means, each of said plurality of projecting portions being arranged so as to be spaced apart from one another with a predetermined distance;
sizing a width of a said projecting portion so as to be substantially identical to, or, preferably, greater than a width of a said recessed portion; and
forcibly inserting under the pressure said plurality of projecting portions, if formed over said fin means, fittedly under the pressure forcibly into said plurality of recessed portions, if formed on said base plate and said plurality of projecting portions, if formed over said base plate, fittedly under the pressure forcibly into said recessed portions, if formed on said fin means, thereby fastening said plurality of fin means and said base plate together.

7. A heat sink in which a base plate and a plurality of fin means disposed over the base plate are assembled together by inserting the fin means fittedly into the base plate,
characterized in that
a plurality of projecting portions and a plurality of recessed portions are formed over the said fin means and the said base plate at a plurality of locations, respectively, at which the said fin means and the said base plate are to be fastened together, with each of the said plurality of projecting portions being arranged so as to be spaced apart from one another with a predetermined distance;
a said projecting portion has a width which is substantially identical to, or, preferably, greater than a width of a said recessed portion; and
under pressure, said plurality of projecting portions if formed over the said fin means are fittedly inserted forcibly into said plurality of recessed portions if formed said base plate whereas said plurality of projecting portions if formed over said base plate are fittedly forcibly inserted into said plurality of recessed portions if formed over said fin means so that said plurality of fin means and said base plate may be fastened together.

8. A heat sink, as set forth in claim 7, characterized in that:
in at least either of the said fin means and the said base plate, the said projecting portions is provided with a first positioning portion and a first caulking portion; that at least one of the said positioning portion and the said caulking portion is inclined with a given angle; and
a stress and a drag which are produced by said angle when under pressure, said plurality of projecting portions if formed over the said fin means are fittedly inserted forcibly into the said base plate whereas said plurality of projecting portions if formed over said base plate are fittedly inserted forcibly into said fin means, are used to further enhance the tightness of fastening between said fin means and said base plate.

9. A method of joining together of a pair of extruded members,
characterized in that
said pair of extruded members have, respectively, a first and a second surface to be joined together and are a first extruded member having either of a plurality of projecting stripes and a plurality of projecting and recessed stripes formed on said first joining surface and a second extruded member independent thereof and having either of a plurality of recessed stripes and a plurality of recessed and projecting stripes formed on said second joining surface;
at least some of said stripes have each a portion which is inclined with an angle with respect to a direction that is vertical to the corresponding joining surface thereof; and
at least one of said first and second joining surfaces has a groove formed therein having a plurality of narrower projecting stripes formed thereon, which are so adapted that when said first and second extruded members are pressed against each other under a pressure so as to be fastened and thereby joined together by each of said projecting stripes being forced into a said recess corresponding thereto, said narrower projecting stripes may form, through a plastic deformation thereof, corresponding projecting stripes on a surface of an object that is sandwiched between said first and second second extruded members.

10. A method of assembling a liquid cooled heat sink, using a method as set forth in claim 9,
characterized in that
said first and second independent extruded members 1 provide at least one surface on which a heat emitting element may be attached; and
said object which is sandwiched between said first and second members is constituted by a tube for transporting a coolant fluid therethrough.

11. A liquid cooled heat sink,
characterized in that
a coolant fluid transporting tube which is formed in a pair of independent extruded members which have been joined together under a pressure has an external surface that is formed with narrow projecting stripes which correspond to narrow stripes formed in a groove that is formed in at least one of said first and second extruded members.

12. A method of assembling a heat sink, comprising the steps of:
providing a fin member having a joining surface to be joined with a base plate that has a heat emitting element to be attached thereto and having a heat emitting portion comprised of a plurality of straight flat plates and a plurality of flat, bent and then flat plates which are alternately arranged and are equally spaced apart axially adjacent to said joining surface and further having on said joining surface any of a plurality of projecting stripes, a plurality of recessed stripes and a plurality of projecting stripes and recessed stripes;
providing the said base plate on a joining surface thereof with any of a like plurality of recessed stripes, a like plurality of projecting stripes and a like plurality of recessed stripes and projecting stripes;
providing at least some of said projecting stripes and recessed stripes with a predetermined angle with respect to said joining surface on which they are provided;
forcibly inserting said projecting stripes of one of said fin member and said base plate under a pressure into said recessed stripes corresponding thereto and of one of said base member and said fin member, thereby causing a stress therein and plastically deforming said stripes associated with said angle, by said angle, to effect a work hardening thereof; and
utilizing an effect of said work hardening to join said fin member and said base member together with an enhanced fastening strength.

13. A heat sink prepared by:
providing a fin member having a joining surface to be joined with a base plate that has a heat emitting element to be attached thereto and having a heat emitting portion comprised of a plurality of straight flat plates and a plurality of flat, bent and then flat plates which are alternately arranged and are equally spaced apart axially adjacent to said joining surface and further having on said joining surface any of a plurality of projecting stripes, a plurality of recessed stripes and a plurality of projecting stripes and recessed stripes;
providing said base plate on a joining surface thereof with any of a like plurality of recessed stripes, a like plurality of projecting stripes and a like plurality of recessed stripes and projecting stripes;
providing at least some of said projecting stripes and recessed stripes with a predetermined angle with respect to said joining surface on which they are provided;
forcibly inserting said projecting stripes of one of said fin member and said base plate under a pressure into said recessed stripes corresponding thereto and of one of said base member and said fin member, thereby causing a stress therein and plastically deforming said stripes associated with said angle, by said angle, to effect a work hardening thereof; and
utilizing an effect of said work hardening to join said fin member and said base member together with an enhanced fastening strength.

14. A heat sink, comprising:
a base plate which is made up of a first extruded member for providing an attachment surface for a heat emitting element; and
a plurality of fin sections each of which is made up of a second extruded member that is independent of said first extruded member for emitting a heat which is transferred from said base plate,
characterized in that:
each of said fin sections is provided with a fluid transport portion for accepting a coolant fluid flow and a heat emitting portion that is located above said fluid transport portion and comprised of a plurality of straight flat plates and a plurality of flat, bent and then flat plates; and
each of said fin sections is joined with said base plate, thereby increasing the heat emitting area of such heat emitting portions thereof.
